Europäisches Patentamt

European Patent Office

Office européen des brevets

(19)

(11) **EP 0 516 562 B1**

(12) **FASCICULE DE BREVET EUROPEEN**

(45) Date de publication et mention
de la délivrance du brevet:
**28.08.1996 Bulletin 1996/35**

(51) Int Cl.6: **G01R 15/24**, G01R 33/032

(21) Numéro de dépôt: **92420166.8**

(22) Date de dépôt: **21.05.1992**

(54) **Dispositif de mesure de courant par fibre optique**

Faseroptische Strommessvorrichtung

Device for measuring current with an optical fibre

(84) Etats contractants désignés:
**CH DE GB IT LI SE**

(30) Priorité: **27.05.1991 FR 9106485**

(43) Date de publication de la demande:
**02.12.1992 Bulletin 1992/49**

(73) Titulaire: **SCHNEIDER ELECTRIC SA**
**F-92100 Boulogne-Billancourt (FR)**

(72) Inventeurs:
• **Barrault, Michel**
**F-38050 Grenoble Cedex 9 (FR)**
• **Royer, Pascal**
**F-38050 Grenoble Cedex 9 (FR)**
• **Kevorkian, Antoine**
**F-38050 Grenoble Cedex 9 (FR)**

(74) Mandataire: **Jouvray, Marie-Andrée et al**
**Schneider Electric SA,**
**Sce. Propriété Industrielle**
**38050 Grenoble Cédex 09 (FR)**

(56) Documents cités:
**EP-A- 0 430 060**      **FR-A- 2 097 299**
**FR-A- 2 622 969**

• **ELECTRONICS LETTERS, vol. 19, no. 15, 21
juillet 1983, pages 578-579, Enage, GB; J. LIZET
et al.: "Reduction of temperature and vibration
sensitivity of a polarimetric current sensor"**
• **REVUE GENERALE DE L'ELECTRICITE, no. 4,
avril 1990, pages 62-67, Paris, FR; P. ROYER et
al.: "Capteur de courant à fibre optique"**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

## Description

La présente invention se rapporte à un dispositif de mesure de courant par fibre optique, dont le principe de mesure est basé sur l'effet FARADAY dans une fibre optique monomode.

Il a déjà été proposé de réaliser un dispositif de mesure du courant dans un conducteur par utilisation de l'effet FARADAY dans une fibre optique monomode faiblement biréfringente qui est enroulée, selon un certain nombre N de spires, autour de ce conducteur.

La lumière, polarisée linéairement et préférentiellement monochromatique, subit sous l'effet du champ magnétique parallèle à sa direction de propagation une rotation de polarisation dite "rotation FARADAY" d'angle F, qui est donnée par la relation suivante:

$$F = VNI$$

où V, qui est la Constante de VERDET du milieu optique, est dans le cas d'une fibre optique en Silice égale à 3 microradians/A pour une longueur d'onde de 780nm.

La mesure, ou détection, de cet angle de rotation de polarisation F permet par conséquent de déduire la valeur de l'intensité I du courant dans le conducteur.

L'article de MM. ROYER, KEVORKIAN, RIVAL, TURC, et CARDOT intitulé "Capteur de courant à fibre optique", et publié dans la "Revue Générale de l'Electricité", 1990, n°4, pages 62 à 67, décrit deux modes de réalisation possibles d'un capteur de courant fonctionnant sur ce principe, et qui se différencient par leur principe de détection, c'est à dire de mesure, de l'angle de rotation de polarisation F.

Dans les deux cas, l'émission de lumière dans la fibre optique monomode est réalisée par l'utilisation d'une diode laser qui constitue la source de lumière monochromatique requise.

La première configuration, décrite dans cet article, utilise une détection, dite "à 90°". La mesure de l'angle F est alors effectuée en séparant l'onde lumineuse sortant de la fibre optique en deux ondes lumineuses polarisées linéairement à 90° l'une de l'autre. On utilise pour ceci un cube séparateur-polariseur à 90°, qui est un élément du commerce. Chacune de ces deux ondes lumineuses est reçue sur une photodiode respective, dont on mesure le courant fourni en conséquence, respectivement I1 et I2. On peut alors, à l'aide d'une électronique appropriée, en déduire la valeur de l'angle F par application de la formule:

$$(I1 - I2) / (I1 + I2) = \sin 2F$$

Un cube séparateur/polariseur a cependant pour inconvénient de posséder un taux de polarisation de 1 à 2% en intensité sur chaque voie, ce qui introduit une distorsion du signal assez pénalisante. Par ailleurs, un tel cube séparateur est de coût plutôt élevé, ce qui pénalise lourdement le prix de revient du capteur.

La seconde configuration évoquée dans cet article utilise une détection dite "à 45°" qui a pour avantage de permettre l'utilisation d'un seul enroulement de fibre optique pour couvrir une large gamme d'intensités de courant à mesurer. Selon ce second procédé, le faisceau lumineux issu de la fibre optique après rotation F est séparé en deux composantes polarisées linéairement dans deux directions faisant entre elles un angle de 45°, et non pas de 90° comme dans le cas précédent. Comme il n'existe en réalité pas dans le commerce de cube séparateur-polariseur à 45°, l'application pratique de ce procédé implique l'utilisation d'une lame semi-réfléchissante et de deux prismes de WOLLASTON reliés chacun à une photodiode, ce qui est encore plus lourd et onéreux que la réalisation précédente.

Par ailleurs, on montre que les intensités I1 et I2 recueillies dans ces deux photodiodes s'expriment par des relations de la forme :

$$I1 = Io (1 + \cos 2F) /4$$

$$I2 = Io (1+ \sin 2F) /4$$

où Io est l'intensité correspondant à la source de lumière émise par la diode laser précitée.

La détermination de sin 2F et de cos 2F nécessite au préalable la détermination de l'intensité Io correspondante à la source. Dans les montages connus cette valeur Io est déterminée par l'utilisation d'une lame semi-réfléchissante , située en amont de la fibre optique et d'une photodiode, ce qui alourdit encore plus ce type d'installation.

On connait par ailleurs d'autres types de dispositif de mesure de courant utilisant l'effet Faraday. Le document FR-A- 2.097.299, notamment, décrit un dispositif dans lequel un faisceau lumineux polarisé par un polariseur traverse un barreau magnétooptique entouré par un bobinage dans lequel circule le courant à mesurer. Le faisceau est ensuite divisé en deux parties traversant deux analyseurs de plans de polarisation symétriques par rapport à celui du polariseur, avant d'être transmise à deux photodiodes connectées à un circuit électronique de traitement. Le document précise que le polariseur peut être un polariseur à réfraction ou un polariseur artificiel en matière plastique transparente contenant des molécules d'hérapatite.

L'invension vise à remédier aux inconvénients des dispositifs connus du type décrit dans l'article précité. Elle se rapporte à cet effet à un dispositif selon la revendication 1.

Préférentiellement, le séparateur-polariseur comporte deux morceaux distincts coplanaires, sensiblement orthogonaux à l'axe du faisceau lumineux, les morceaux de feuille étant deux demi-disques de même diamètre, placés sensiblement bord à bord, de manière à reconstituer un disque complet et coaxial au faisceau lumineux sortant de la fibre, l'angle formé entre les polarisations des deux morceaux étant de 90° ou de 45°. Les deux photodiodes précitées sont avantageusement constituées par un photodétecteur bi-quadrant, avantageusement en forme de disque sensiblement de même diamètre que celui reconstitué par les deux morceaux de feuilles polarisantes, le photodétecteur bi-quadrant étant positionné en aval coaxialement et à faible distance des deux morceaux accolés de feuilles polarisantes en demi-disque.

Dans le cas d'une détection dite "à 45°", l'intensité Io de la source de lumière peut être calculée à partir des courants mesurés. Elle peut également être déterminée en sortie de la fibre optique, par exemple au moyen d'une photodiode recevant directement la lumière sortant de cette fibre et placée derrière un orifice préférentiellement central prévu dans le séparateur polariseur réalisé par les deux morceaux de feuille polarisante. Selon une autre variante, l'intensité Io est déterminée au moyen d'une photodiode recevant la lumière issue de la fibre optique puis réfléchie soit par un miroir préférentiellement placé sur le même support que celui portant les deux morceaux de feuille, soit par les deux morceaux de feuille eux-mêmes.

L'invention sera mieux comprise, et ses avantages et autres caractéristiques ressortiront, lors de la description suivante de deux exemples non-limitatifs de réalisation du dispositif de mesure de courant, en référence aux dessins schématiques annexés dans lesquels:

La figure 1 est un schéma synoptique d'ensemble du dispositif de mesure, ou capteur, de courant dans une première forme de réalisation, utilisant une détection dite "à 90°";

La figure 2 montre un mode de réalisation préférentiel du séparateur-polariseur utilisé dans le dispositif de la figure 1 et vu en plan;

La figure 3 est une vue détaillée du module de détection, destiné à la détermination de la rotation FARADAY, qui est utilisé dans ce dispositif, le module étant vu en coupe longitudinale selon III-III de la figure 4;

La figure 4 est une vue du même module, en coupe transversale selon IV-IV de la figure 3;

La figure 5 montre la partie détection utilisée dans une deuxième forme de réalisation du capteur de courant, utilisant une détection dite "à 45°";

La figure 6 montre, de façon analogue à la figure 2, le séparateur-polariseur qui est utilisé pour la seconde forme de réalisation;

La figure 7 montre une variante de réalisation de la partie détection du capteur selon la figure 1; et

La figure 8 montre comment peut aisément être réalisé, avantageusement par découpe laser, un séparateur-polariseur tel que celui selon la figure 6.

Les figures 9 et 10 illustrent deux variantes du séparateur-polariseur d'un dispositif selon l'invention.

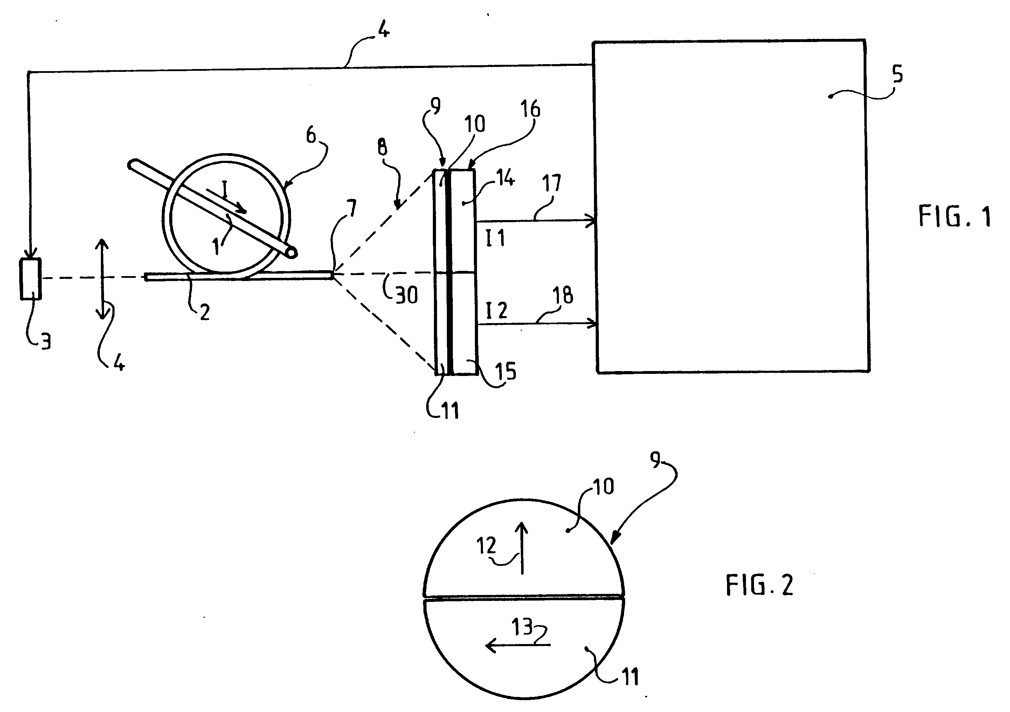

Les figures 1 et 2 représentent un dispositif de mesure par voie optique de l'intensité I du courant qui parcourt un conducteur 1, cette intensité étant par exemple de l'ordre de quelques dizaines de milliers d'ampères pour fixer les idées.

Le dispositif utilise l'effet FARADAY, ou "rotation FARADAY" d'angle F, qui est crée dans une fibre optique 2, monomode, faiblement biréfringente, et parcourue par une onde lumineuse monochromatique et polarisée linéairement, qui lui est appliquée par une diode laser émettrice 3, avec interposition préférentielle d'une lentille 4 de focalisation de la lumière émise par la diode 3.

La diode laser émettrice 3 est elle-même alimentée en énergie électrique par une connexion 4 reliée à un bloc électronique 5, qui est le bloc d'alimentation et d'analyse du dispositif.

Dans l'exemple représenté, la fibre optique monomode 2 est enroulée en une spire 6 autour du conducteur 1, et l'onde lumineuse voit en conséquence son plan de polarisation subir une rotation FARADAY d'angle F donné par la relation:

$$F = V.I$$

avec V (constante de Verdet de la silice) égale à 3 microradians/A.

Dans l'exemple de réalisation selon la figure 1, la mesure de l'angle F est réalisée par une détection dite "à 90°", pour laquelle il est nécessaire de séparer le faisceau lumineux 8 en sortie 7 de la fibre 2, en deux faisceaux dont les axes de polarisation sont perpendiculaires l'un à l'autre.

Ceci est, conformément à un mode de réalisation de l'invention, réalisé en appliquant le faisceau sortant 8, éventuellement par l'intermédiaire d'une lentille, à un disque séparateur-polariseur 9 constitué de deux morceaux coplanaires 10,11 de feuille polarisante qui sont chacun aptes à privilégier une direction de polarisation, les deux directions de polarisation, respectivement 12 et 13 (figure 2), étant orthogonales l'une à l'autre.

Les deux morceaux 10 et 11 ont chacun une forme de demi-disque de même diamètre, et sont accolés l'un contre l'autre par leur diamètre de découpe de façon à reconstituer à eux deux un disque entier 9 (voir sur la figure 2) qui est de préférence orthogonal à l'axe 30 du faisceau lumineux sortant 8, et qui est de même axe 30.

Les intensités lumineuses recueillies par chacun de ces demi-disques polarisants coplanaires 10,11 sont détectées par deux photodiodes respectives 14,15 qui sont accolées au séparateur-polariseur, derrière celui-ci. Très simplement, elle sont constituées par les deux moitiés respectives 14,15 d'un photodétecteur bi-quadrant circulaire 16 du commerce, qui est choisi d'un diamètre égal à celui du séparateur-polariseur 9.

Les intensités I1 et I2 des courants détectés en sortie des photodiodes 14 et 15 sont mesurées et traitées par le bloc électronique précité 5, auquel les photodiodes sont reliées par des connexions 17 et 18. Le bloc 5 en déduit la valeur de l'angle de rotation FARADAY F par application de la formule :

$$(I1 - I2) / (I1 + I2) = \sin 2F$$

Comme décrit dans l'article précité, l'annulation de l'activité optique due à des variations de température est avantageusement effectuée en réalisant une double torsion inverse de la fibre optique 2. Chaque demi-longueur de fibre est torsadée à des taux de torsion égaux, mais de sens opposés. Une compensation thermique est en outre avantageusement réalisée aussi par le traitement effectué par le bloc électronique 5.

Pour réaliser, selon un principe en soi connu, le réglage à courant nul de la direction de polarisation de la lumière en sortie 7 de la fibre 2, à 45° des axes 12 et 13 des polariseurs 10 et 11, le module de détection 9,16 proprement dit est rendu libre en rotation, ce qui évite d'avoir à tourner la fibre 2 pour réaliser le réglage à courant nul. Par ailleurs, il est avantageusement prévu la possibilité de régler avec précision l'orthogonalité des directions de polarisation 12 et 13 en permettant une certaine rotation des demi-disques 10 et 11 l'un par rapport à l'autre.

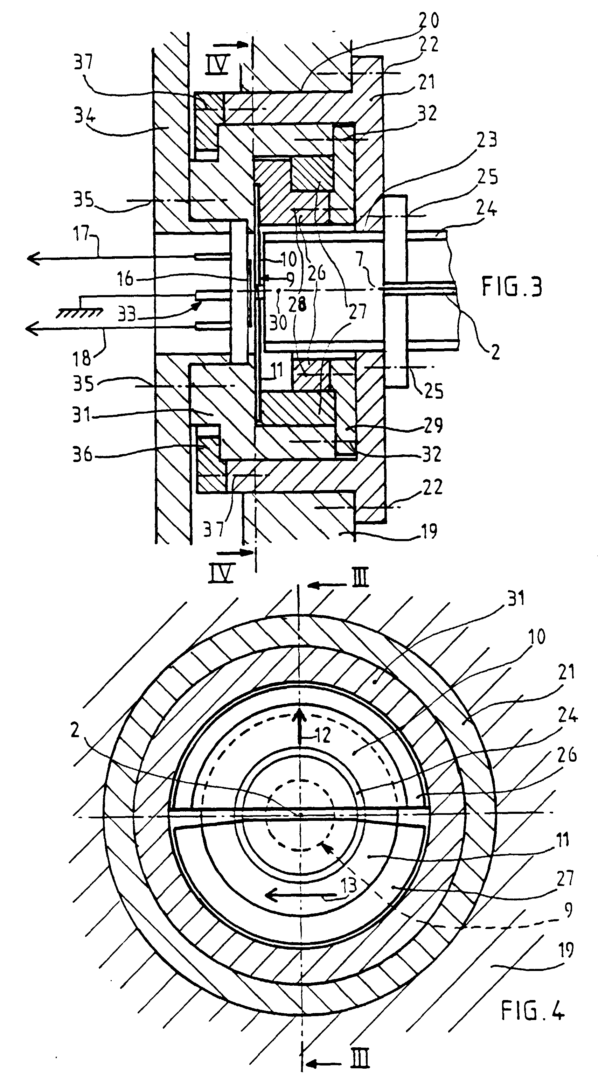

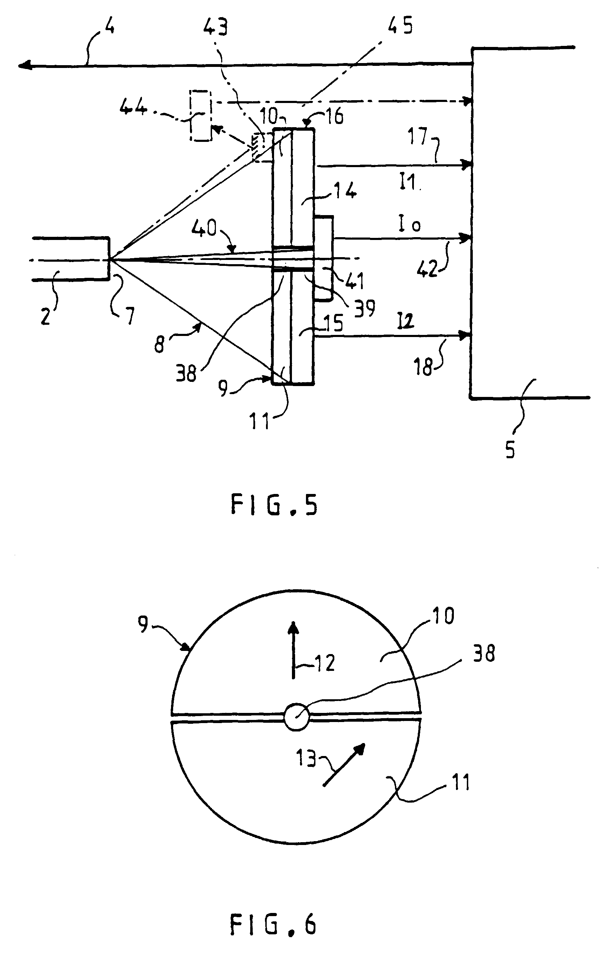

Les deux possibilités de réglages apparaissent clairement sur les figures 3 et 4, qui représentent de manière détaillée le module de détection proprement dit.

En se référant aux figures 3 et 4, le module de détection comporte une pièce de support d'ensemble, ou châssis, 19 en forme de paroi verticale percée d'un orifice circulaire 20 qui reçoit un guide circulaire, ou couvercle, 21 maintenu en position par des vis 22, dont seul l'axe est schématisé sur la figure 3.

Dans un orifice central 23 de ce guide 21 est encastrée une embase 24 qui porte la fibre optique 2 et qui est maintenue en position par des vis 25. L'embase 24, et donc la fibre (2), sont par conséquent montés fixes dans le châssis 19.

Le demi-disque polariseur supérieur 10 est collé par son pourtour sur une pièce en laiton 26. De même, le demi-disque polariseur inférieur 11 est collé par son pourtour sur une autre pièce en laiton 27. Les pièces 26,27 sont non seulement agencées et positionnées pour que les demi-disques 10 et 11 forment à eux deux un disque complet 9 coaxial à la fibre 2 et orthogonal à son axe de sortie 30, mais encore sont imbriquées l'une dans l'autre pour leur permettre une rotation relative apte à permettre un réglage fin au banc optique de l'orthogonalité des axes de polarisations privilégiés 12 et 13. Le blocage en position voulue est ensuite effectué par des vis 28 qui assurent la fixation et le serrage des supports 26,27 contre un couvercle 29.

Les deux pièces de support et de réglage 26 et 27 sont par ailleurs maintenues dans un couvercle 31 qui est lui-même rendu solidaire du couvercle 29 par des vis 32.

La photodiode bi-quadrant 16 et sa broche de connexion 33 sont par ailleurs fixées sur un support externe 34 qui est rendu solidaire du couvercle 31 par des vis 35. Le couvercle 31 est lui-même maintenu par une rondelle de blocage 36 qui est solidarisée à la pièce 21 par des vis 37.

Ainsi les pièces 26,27,28,29,31,34 forment un ensemble rigide qui, après desserrage des vis de blocage 37, peut tourner dans le guide 21 solidaire du support d'ensemble 19. Le réglage à courant nul précité est donc réalisé, sans toucher à la fibre 2, par rotation de l'ensemble rigide, qui est ensuite bloqué en position par resserrage des vis 37.

L'invention est également applicable, et de manière particulièrement avantageuse, à une détection dite "à 45°", et une forme de réalisation préférentielle du module de détection correspondant est schématiquement représentée sur les figures 5 et 6.

Cette forme de réalisation diffère de la précédente par le fait que les axes de polarisation 12 et 13 des deux demi-disques polariseurs 10 et 11 sont orientés à 45° l'un par rapport à l'autre, et non pas à 90°. Dans ces conditions, il s'agit d'une détection dite "en sinus-cosinus" et l'angle de rotation F peut être extrait des relations :

$$I1 = Io (1 + \cos 2F) /4$$

$$I2 = Io (1 + \sin 2F) /4$$

Ceci nécessite la connaissance de Io, intensité correspondante à la lumière émise par la source 3. Io peut être calculée par le bloc électronique 5 à partir des valeurs de I1 et I2. On peut en effet obtenir Io à partir de la formule:

$$Io = 4I [(I1 + I2) - \sqrt{2I1I2} ].$$

Dans le mode de réalisation préférentiel représenté sur les figures 5 et 6, la détermination de Io est réalisée simplement par le fait que le disque séparateur-polariseur 9 et le photodétecteur bi-quadrant 16 sont chacun percés d'un petit orifice axial, respectivement 38 et 39, ces deux orifices coaxiaux étant sensiblement de mêmes diamètres.

En conséquence, les deux orifices 38,39 sont traversés par la partie centrale 40 du faisceau lumineux 8 en sortie 7 de la fibre 2, ce faisceau étant représentatif de l'intensité Io de la source.

Une photodiode auxiliaire 41 est accolée au photodétecteur 16, derrière celui-ci, et l'intensité Io qu'elle détecte ainsi est introduite, par un conducteur 42, pour exploitation dans le bloc électronique 5.

Une alternative, également avantageuse, consisterait à ne pas prévoir d'orifices 38 et 39 dans les disques 9 et 16, mais à coller sur le disque 9, par exemple à la partie supérieure comme indiqué en traits mixtes, et sur la face située vis à vis de la sortie de la fibre 7, un petit miroir réfléchissant 43, associé à une photo-diode de mesure 44 recevant le faisceau réfléchi par le miroir et relié au bloc 5 par une connexion 45. Il peut également être envisagé de mesurer Io à partir de la lumière directement réfléchie par le polariseur.

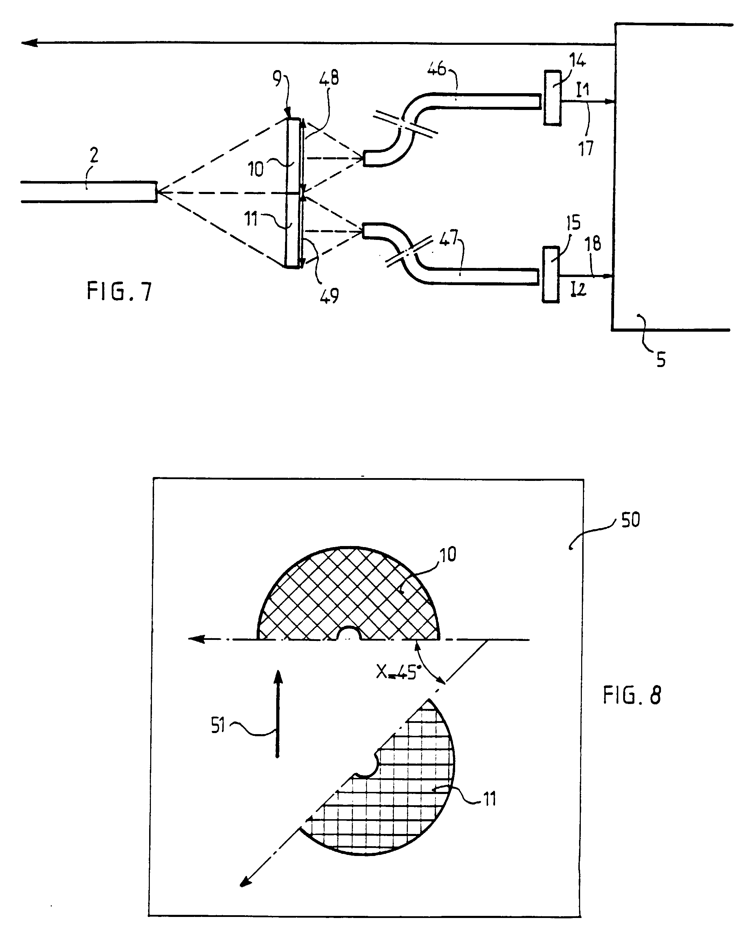

Les deux réalisations précédentes sont des réalisations compactes, pour lesquelles il est souhaité que les photodétecteurs soient pratiquement accolés aux polariseurs-séparateurs. Ceci ne constitue bien sûr pas la seule possibilité et, dans le cas où il est au contraire souhaité que les photodétecteurs de mesure soit éloignés de la fibre 2, et par conséquent du conducteur 1, il est possible, comme schématisé sur la figure 7, de déporter les photodétecteurs.

En se reportant à la figure 7, il s'agit, à titre d'exemple, d'un module de détection "à 90°", qui comporte le même disque séparateur-polariseur 9 que sur la figure 1, mais pour lequel les photodétecteurs 14 et 15, standards, sont déportés à distance au moyen de deux fibres optiques additionnelles 46 et 47 associées à deux lentilles focalisatrices 48 et 49. Bien entendu, un tel système est applicable à une détection "à 45°" selon la figure 5 : il faudrait alors prévoir de plus une fibre auxiliaire placée en sortie de l'orifice central 38 du disque 9.

Un moyen commode pour réaliser, dans un cas comme dans l'autre, le disque séparateur-polariseur 9, est schématisé sur la figure 8. Il consiste à se procurer dans le commerce une feuille polarisante 50, de direction de polarisation privilégiée 51, puis de découper, préférentiellement au rayon laser, dans cette feuille 50, deux demi-disques 10 et 11 orientés sur cette feuille selon l'angle X souhaité, ici égal à 45°.

Ces deux demi-disques, munis d'un demi-orifice central ou non selon le cas, sont ensuite simplement assemblés bord à bord pour reconstituer un disque plein, selon la figure 6 ou selon la figure 2, selon le cas. On bénéficie ainsi d'une découpe aisément programmable, s'il s'agit par exemple d'une découpe au laser, et dans ce cas d'excellente qualité. Le réglage précis sur banc optique des axes de polarisations respectifs 12 et 13 n'est en outre plus vraiment nécessaire.

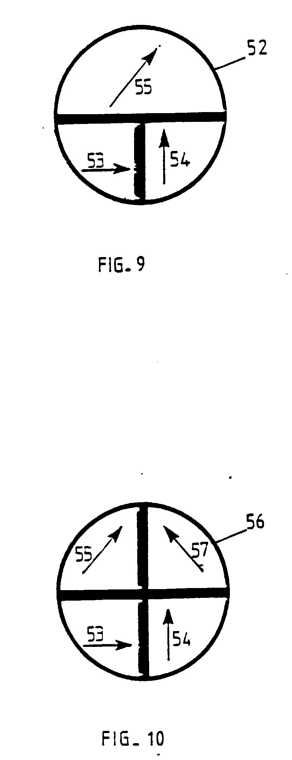

L'invention n'est pas limitée à un séparateur-polariseur (9) constitué de deux morceaux. Elle s'applique de manière analogue à un séparateur-polariseur en trois ou quatre morceaux, comme illustré par exemple sur les figures 9 et 10.

Sur la figure 9, le séparateur-polariseur est constitué de trois morceaux. La direction 53 de polarisation de l'un des morceaux, par exemple formant un quart de disque, fait un angle de 90° avec la direction de polarisation 54 d'un second morceau, également en forme d'un quart de disque sur la figure, et un angle de 45° avec la direction de polarisation 55 du troisième morceau. Ce dernier est, dans le mode de réalisation représenté, constitué par un demi-disque, les trois morceaux étant accolés de manière à constituer un disque. On obtient ainsi trois signaux dont les intensités I3,I4 et I5 correspondent respectivement à :

$$I3 = Io\ (1 + \cos 2F) / 8$$

$$I4 = Io\ (1 - \cos 2F) / 8$$

$$I5 = Io\ (1 + \sin 2F) / 4$$

Io peut alors être obtenu par : Io = 4 (I3 + I4) et l'angle F calculé à partir de I5 et I3 - I4

Bien entendu un photodétecteur approprié est disposé en aval du séparateur-polariseur pour recueillir les signaux correspondants.

Le séparateur-polariseur 56 selon la figure 10 est constitué de quatre morceaux, chacun formant un quart de disque. Les directions de polarisation des morceaux formant entre elles, deux à deux, soit un angle de 90°, soit un angle de 45°. On retrouve en effet sur la figure 10 les directions 53,54 et 55 de la figure 3, la quatrième direction 57 faisant un angle de 90° avec la direction 55.

On obtient, par exemple au moyen d'un photodétecteur à quatre quadrants, quatre signaux, I3,I4,I6 et I7, avec

$$I6 = Io\ (1 + \sin 2F) /8$$

$$I7 = Io\ (1 - \sin 2F) /8$$

On peut alors calculer :

$$Is = I6 - I7 = (Io.\sin 2F) /4$$

$$Ic = I3 - I4 = (Io.\cos 2F) /4$$

$$Io = 2\ (I3 + I4 + I6 + I7)$$

et en déduire la valeur de F.

## Revendications

1. Dispositif de mesure de l'intensité (I) du courant traversant un conducteur (1), dispositif comportant une fibre optique monomode (2) faisant un nombre prédéterminé de tours (6) autour du conducteur et parcourue par une onde lumineuse polarisée linéairement, fournie par une diode laser émettrice (3), et un dispositif de mesure disposé à la sortie de la fibre et comportant un séparateur-polariseur (9) séparant le faisceau lumineux (8) issu de la fibre (2) en composantes polarisées linéairement dans des directions faisant entre elles des angles prédéterminés, chaque composante étant reçue par une photodiode (14,15) associée connectée (17,18) à un bloc électronique (5) auquel elle fournit des signaux de courant (I1, I2) correspondant à son éclairement, ledit bloc calculant en conséquence la rotation d'angle (F) de la direction de polarisation linéaire de l'onde lumineuse sous l'action du champ magnétique créé par le courant (I), et déduisant de ladite mesure de la rotation d'angle l'intensité (I) à mesurer, dispositif caractérisé en ce que le séparateur-polariseur (9) est constitué d'au moins deux morceaux (10,11) de feuille polarisante (50), traversés par le faisceau lumineux (8) issu de la fibre (2), les polarisations relatives (12, 13 ; 53, 54, 55, 57) des morceaux de feuille polarisante (10,11) faisant entre elles lesdits angles prédéterminés, une desdites photodiodes (14,15) étant associée à chacun (10,11) des morceaux de feuille.

2. Dispositif de mesure d'intensité selon la revendication 1, caractérisé en ce que le séparateur-polariseur (9) comporte deux morceaux distincts (10,11), coplanaires et sensiblement orthogonaux à l'axe du faisceau lumineux, les deux morceaux de feuille (10,11) étant deux demi-disques de même diamètre placés sensiblement bord à bord de manière à reconstituer un disque complet (9) qui est placé coaxialement au faisceau lumineux (8) issu de la fibre (2), l'angle formé entre les polarisations des deux morceaux étant de 90° ou de 45°.

3. Dispositif selon la revendication 2, caractérisé en ce que ces deux demi-disques(10,11) sont découpés, de préférence au rayon laser, avec une orientation relative (X) égale à la différence d'angle de polarisation souhaité, dans une même feuille (50) en matière polarisante (51), puis assemblés bord à bord pour former le disque complet (9).

4. Dispositif selon l'une des revendications 1 à 3, caractérisé en ce que, l'angle formé entre les polarisations des deux morceaux étant de 45°, une photodiode supplémentaire (41) est placée derrière un orifice (38) axial du séparateur-polariseur (9) et fournit au bloc électronique (5) un signal représentatif de l'intensité (Io) du faisceau émis par ladite diode émettrice (3).

5. Dispositif selon la revendication 4, caractérisé en ce que les photodiodes (14,15) associées aux deux demi-disques sont constituées par un photodétecteur bi-quadrant (16) pratiquement accolé derrière le séparateur-polariseur (9), le photodétecteur comportant un orifice (39) contigu à l'orifice du séparateur-polariseur, afin de laisser passer, vers la photodiode (41) supplémentaire, la lumière (40) issue de la fibre (2).

6. Dispositif selon l'une des revendications 1 à 3, caractérisé en ce que, l'angle formé entre les polarisations des deux morceaux étant de 45°, un miroir (43) est disposé sur le trajet du faisceau de sortie de la fibre optique (2), une photodiode auxiliaire (44) recevant la lumière réfléchie par le miroir fournissant au bloc électronique (5) un signal représentatif de l'intensité (Io) du faisceau émis par la diode émettrice (3).

7. Dispositif selon la revendication 2, caractérisé en ce que les photodiodes (14,15) associées aux deux demi-disques (10,11) sont constituées par un photodétecteur bi-quadrant, en forme de disque (16) de même diamètre que celui que constitue le séparateur-polariseur (9), placé en aval et à faible distance du séparateur-polariseur (9).

8. Dispositif selon l'une des revendications 1 à 4, ou 6, caractérisé en ce que des fibres optiques auxiliaires (46,47) sont prévues pour déporter les photodiodes (14,15,41,44) à distance du séparateur-polariseur (9).

9. Dispositif selon la revendication 1, caractérisé en ce qu'un premier morceau (10) de feuille polarisante est placé sur un premier support (26), tandis qu'un autre morceau (11) est placé sur un deuxième support (27), et en ce que les deux supports sont déplaçables en rotation l'un par rapport à l'autre afin de régler les orientations respectives (12,13) des polarisations privilégiées des deux morceaux (10,11).

10. Dispositif selon l'une des revendications 1 et 9, caractérisé en ce qu'il comporte des moyens (24,21) de maintien en position de l'extrémité (7) de sortie de la fibre optique (2), et des moyens de support (34,31,29,26,27), destinés à supporter au moins le séparateur-polariseur (10,11) formant un ensemble rigide déplaçable en rotation pour effectuer, sans toucher à la fibre (2), le réglage du dispositif à courant nul.

**Patentansprüche**

1. Anordnung zur Messung eines einen Leiter (1) durchfließenden Stroms (I), die eine mit einer bestimmten Windungszahl (6) um den Leiter gewikkelte und von einer linear polarisierten, von einer Laserdiode (3) ausgesandten Lichtwelle durchlaufene Monomode-Lichtleitfaser (2) sowie eine am Ausgang der Lichtleitfaser angeordnete und mit einer Polarisationsweiche (9) bestückte Meßanordnung umfaßt, welche den aus der Lichtleitfaser (2) austretenden Lichtstrahl (8) in linear und in Richtungen mit bestimmten Winkeln zueinander polarisierte Teilstrahlen aufspaltet, wobei jeder Teilstrahl eine zugeordnete Fotodiode (14, 15) beaufschlagt, die mit einer Elektronikschaltung (5) verbunden (17, 18) ist und dieser zu ihrer Lichtbestrahlung proportionale Stromsignale (I1, I2) liefert, wobei die genannte Elektronikschaltung dann die Winkeldrehung (F) der Richtung der linearen Polarisation der Lichtwelle unter der Einwirkung des vom Strom (I) erzeugten Magnetfelds berechnet und aus der genannten Messung der Winkeldrehung den zu messenden Strom (I) ableitet, dadurch gekennzeichnet, daß die Polarisationsweiche (9) aus mindestens zwei, von dem aus der Lichtleitfaser (2) austretenden Lichtstrahl (8) durchsetzten Abschnitten (10, 11) einer Polarisationsfolie (50) besteht, wobei die relativen Polarisationsrichtungen (12, 13; 53, 54, 55 57) der Polarisationsfolienabschnitte (10, 11) untereinander die genannten bestimmten Winkel bilden und jeweils eine der genannten Fotodioden (14, 15) jedem der Folienabschnitte (10, 11) zugeordnet ist.

2. Strommeßanordnung nach Anspruch 1, dadurch gekennzeichnet, daß die Polarisationsweiche (9) zwei getrennte, in einer Ebene liegende und annähernd rechtwinklig zur Achse des Lichtstrahls angeordnete Abschnitte (10, 11) umfaßt, wobei diese Folienabschnitte (10, 11) aus zwei Halbscheiben gleichen Durchmessers bestehen, die so angeordnet sind, daß sie mit ihren Rändern annähernd aneinanderstoßen und so eine, koaxial zu dein aus der Lichtleitfaser (2) austretenden Lichtstrahl (8) ausgerichtete Vollscheibe (9) bilden, wobei der zwischen den Polarisationsachsen der beiden Abschnitte entstehende Winkel 90° oder 45° beträgt.

3. Anordnung nach Anspruch 2, dadurch gekennzeichnet, daß diese beiden Halbscheiben (10, 11), vorzugszueise mit Hilfe eines Lasers, mit einer relativen Ausrichtung (X) zueinander entsprechend der gewünschten Polarisationswinkeldifferenz aus einer gleichen Folie (50) aus polarisierendem Material (51) ausgeschnitten und anschließend mit den Rändern zusammengefügt werden, um die Vollscheibe (9) zu bilden.

4. Anordnung nach einem der Ansprüche 1 bis 3, dadurch gekennzeichnet, daß der zwischen den Polarisationsrichtungen der beiden Abschnitte gebildete Winkel 45° beträgt und daß eine zusätzliche Fotodiode (41) hinter einer in der Polarisationsweiche (9) ausgebildeten axialen Öffnung (38) angeordnet ist und die Elektronikschaltung (5) mit einem Signal beaufschlagt, das die Intensität (10) des von der genannten Diode (3) ausgesandten Lichtstrahls abbildet.

5. Anordnung nach Anspruch 4, dadurch gekennzeichnet, daß die den beiden Halbscheiben zugeordneten Fotodioden (14, 15) als Zweiquadrant-Fotodetektor (16) ausgebildet sind, der praktisch direkt auf die Rückseite der Polarisationsweiche (9) aufgesetzt ist, wobei der Fotodetektor eine an die Öffnung der Polarisationsweiche angepaßte Öffnung (39) aufweist, um das aus der Lichtleitfaser (2) austretende Licht (40) in Richtung der zusätzlichen Fotodiode (41) passieren zu lassen.

6. Anordnung nach einem der Ansprüche 1 bis 3, dadurch gekennzeichnet, daß der zwischen den Polarisationsrichtungen der beiden Abschnitte gebildete Winkel 45° beträgt, daß ein Spiegel (43) in der Bahn des aus der Lichtleitfaser (2) austretenden Lichtstrahls angeordnet ist und daß eine zusätzliche Fotodiode (44) mit dem durch den Spiegel reflektierten Licht beaufschlagt wird und ein Signal an die Elektronikschaltung (5) weiterleitet, das die Intensität (10) des von der Diode (3) ausgesandten Lichtstrahls abbildet.

7. Anordnung nach Anspruch 2, dadurch gekennzeichnet, daß die den beiden Halbscheiben (10, 11) zugeordneten Fotodioden (14, 15) als Zweiquadrant-Fotodetektor in Form einer Scheibe (16) ausgeführt sind, die den gleichen Durchmesser wie die Scheibe der Polarisationsweiche (9) aufweist, wobei der Zweiquadrant-Fotodetektor in geringem Abstand hinter der Polarisationsweiche (9) angeordnet ist.

8. Anordnung nach einem der Ansprüche 1 bis 4 oder 6, dadurch gekennzeichnet, daß zusätzliche Lichtleitfasern (46, 47) zur rückversetzten Anordnung der Fotodioden (14, 15, 41, 44) in einem größeren Abstand zur Polarisationsweiche (9) vorgesehen sind.

9. Anordnung nach Anspruch 1, dadurch gekennzeichnet, daß ein erster Polarisationsfolienabschnitt (10) auf einem ersten Trägerkörper (26) und ein anderer Abschnitt (11) auf einem zweiten Trägerkörper (27) angebracht sind, und daß die beiden Trägerkörper gegeneinander verdreht werden können, um die relative Ausrichtung (12, 13) der Vorzugs-Polarisationsrichtungen der beiden Abschnitte (10, 11) einstellen zu können.

10. Anordnung nach einem der Ansprüche 1 bis 9, dadurch gekennzeichnet, daß sie Mittel (24, 21) zum lagestabilen Halten des Ausgangsendes (7) der Lichtleitfaser (2) sowie Trägermittel (34, 31, 29, 26, 27) zur Aufnahme mindestens der Polarisationsweiche (10, 11) aufweisen, die eine biegesteife, drehbar ausgeführte Einheit bilden, um ohne Berührung der Lichtleitfaser (2) die Nullstrom-Einstellung des Systems vornehmen zu können.

**Claims**

1. A device for measuring the current intensity (I) flowing in a conductor (1), a device comprising a monomode optic fiber (2) making a predetermined number of turns (6) around the conductor and in which there flows a linearly polarized light wave, supplied by an emitting laser diode (3), and a measuring device located at the output of the fiber and comprising a separator-polarizer (9) separating the light beam (8) output from the fiber (2) into components linearly polarized in directions forming predetermined angles between one another, each component being received by an associated photodiode (14, 15) connected (17, 18) to an electronic unit (5) to which it supplies current signals (11, 12) corresponding to its lighting, said unit consequently computing the angle rotation (F) of the linear polarization direction of the light wave due to the effect of the magnetic field created by the current (I), and deducing from said measuring of the angle rotation the current intensity (I) to be measured, a device characterized in that the separator-polarizer (9) is formed by at least two pieces (10, 11) of polarizing foil (50), through which the light beam (8) output from the fiber (2) passes, the relative polarizations (12, 13; 53, 54, 55, 57) of the pieces of polarizing foil (10, 11) making said predetermined angles between one another, one of said photodiodes (14, 15) being associated with each (10, 11) of the pieces of foil.

2. The device for measuring current intensity according to claim 1, characterized in that the separator-polarizer (9) comprises two distinct pieces (10,11), coplanar and appreciably orthogonal to the axis of the light beam, the two pieces of foil (10,11) being two half-disks of the same diameter placed appreciably edge to edge in such a way as to reconstitute a complete disk (9) which is placed coaxially to the light beam (8) output from the fiber (2), the angle formed between the polarizations of the two pieces being 90° or 45°.

3. The device according to claim 2, characterized in that these two half-disks (10,11) are cut out, preferably by laser beam, with a relative onentation (X) equal to the required polarization angle difference, from a single same foil (50) of polarizing material (51), then assembled edge to edge to form the complete disk (9).

4. The device according to one of the claims 1 to 3, characterized in that, the angle formed between the polarizations of the two pieces being 45°, an additional photodiode (41) is placed behind an axial orifice (38) of the separator-polarizer (9) and supplies to the electronic unit (5) a signal representative of the intensity (Io) of the beam emitted by said emitting diode (3).

5. The device according to claim 4, characterized in that the photodiodes (14,15) associated with the two half-disks are formed by a two-quadrant photodiode (16) practically adjoined behind the separator-polarizer (9), the photodetector comprising an orifice (39) contiguous to the orifice of the separator-polarizer, in order to let the light (40) output from the fiber (2) pass to the additional photodiode (41).

6. The device according to one of the claims 1 to 3, characterized in that, the angle formed between the polarizations of the two pieces being 45°, a mirror (43) is located on the path of the beam output from the optic fiber (2), an auxiliary photodiode (44) receiving the light reflected by the mirror supplying to the electronic unit (5) a signal representative of the intensity (Io) of the beam emitted by the emitting diode (3).

7. The device according to claim 2, characterized in that the photodiodes (14,15) associated with the two half-disks (10,11) are formed by a two-quadrant photodiode, in the shape of a disk (16) of the same diameter as that constituted by the separator-polarizer (9), located downline and a small distance from the separator-polarizer (9).

8. The device according to one of the claims 1 to 4, or 6, characterized in that the auxiliary optic fibers (46, 47) are designed to enable the photodiodes (14, 15, 41, 44) to be located at a distance from the separator-polarizer (9).

9. The device according to claim 1, characterized in that a first piece (10) of polarizing foil is placed on a first support (26), whereas another piece (11) is placed on a second support (27), and in that the two supports are movable in rotation with respect to one another in order to adjust the respective orientations (12,13) of the favoured polarizations of the two pieces (10,11).

10. The device according to one of the claims 1 and 9, characterized in that it comprises means (24, 21) for holding the output end (7) of the optic fiber (2) in position, and support means (34, 31, 29, 26, 27) designed to support at least the separator-polarizer (10, 11) forming a rigid assembly movable in rotation to perform adjustment of the device at zero current, without touching the fiber (2).

FIG. 1

FIG. 2

FIG.3

FIG.4

FIG.5

FIG.6

FIG.7

FIG. 8

FIG. 9

FIG. 10